# EUROPÄISCHE PATENTSCHRIFT

(11) **EP 3 835 728 B1**
(45) Veröffentlichungstag und Bekanntmachung des Hinweises auf die Patenterteilung: **08.03.2023**
(21) Anmeldenummer: 20209564.2
(22) Anmeldetag: 24.11.2020
(51) Int. Cl.: G01D 11/24, G01P 1/12, G01R 33/02, G07C 5/00, G07C 7/00

(54) **MAGNETFELDSENSOR**
MAGNETIC FIELD SENSOR
CAPTEUR DE CHAMP MAGNÉTIQUE

(30) Priorität: 13.12.2019 DE 102019219620
(43) Veröffentlichungstag der Anmeldung: 16.06.2021
(73) Patentinhaber: Continental Automotive Technologies GmbH, 30165 Hannover (DE)
(72) Erfinder: Dohmen, Ralf - c/o Continental Automotive GmbH, 65824 Schwalbach a. Ts. (DE); Spitz, Holger - c/o Continental Automotive GmbH, 65824 Schwalbach a. Ts. (DE)
(74) Vertreter: Continental Corporation

(56) Entgegenhaltungen:
- DE-A1-102008 003 341
- DE-A1-102014 215 920
- DE-B3-102014 205 308
- DE-U1- 29 718 790

## Beschreibung

Die Erfindung bezieht sich auf einen Magnetfeldsensor mit einem Sensorgehäuse und mit einer in dem Sensorgehäuse angeordneten Leiterplatte.

Ein Magnetfeldsensor der vorgenannten Art ist z. B. als sogenannter Geschwindigkeitsgeber für einen Fahrtenschreiber, auch bezeichnet als Tachograph, in einem Kraftfahrzeug, insbesondere Nutzfahrzeug, bekannt. Der Magnetfeldsensor wird in ein Getriebegehäuse eines Getriebes des Kraftfahrzeuges eingeschraubt und erfasst mittels eines Sensorkopfs eine Bewegung eines Getriebezahnrades des Getriebes. Auf einer Leiterplatte des Magnetfeldsensors können z. B. ein Sensorelement und beispielsweise elektronische Bauteile, die einer Erfassung und/oder Aufbereitung eines Sensorsignals dienen, angeordnet sein. Eine dauerhaft zuverlässige Funktionsweise des Magnetfeldsensors erfordert einen Schutz insbesondere auch der elektronischen Bauteile des Magnetfeldsensors vor aggressiven Umgebungseinflüssen, wie hohen Temperaturen und Schmierstoffen, in dem Getriebegehäuse. Diesem Schutz dient unter anderem das Sensorgehäuse. Aufgrund der erforderlichen hohen Zuverlässigkeit von mit dem Fahrtenschreiber aufgezeichneten Daten ist es von Bedeutung, eine Manipulation des Magnetfeldsensors und aus einer solchen Manipulation folgende Datenverfälschungen zu vermeiden und zu unterbinden.

Aus DE 10 2008 003 341 A1 ist eine Sensorvorrichtung mit einem Sensor, der von einem Sensorgehäuse zumindest teilweise umgeben und auf einer Leiterplatte angeordnet ist, bekannt. Zu einer korrekten Positionierung der Leiterplatte in dem Gehäuse kann ein Positioniermittel vorgesehen sein. Ferner kann in dem Gehäuse eine Gegenfläche vorgesehen sein, die mit dem Positioniermittel zusammenwirkt.

Einen Drehwertgeber mit einem Gehäuse, in welchem eine Leiterplatte mit einer Schaltung angeordnet ist, offenbart DE 297 18 790 U1. Das Gehäuse ist als eine einseitig offene Hülse ausgebildet und von einer Vergussmasse ausgefüllt. An einer Innenseite des Gehäuses können Vorsprünge angeformt sein.

Aus DE 10 2014 215 920 A1 ist eine Sensorbaugruppe bekannt, bei der ein als Bechergehäuse ausgestaltetes Gehäuse mit einem an dem Bechergehäuse ausgebildeten Steckerkragen vorgesehen ist. Das Bechergehäuse weist innerhalb des Steckerkragens eine Öffnung auf, durch welche ein Schaltungsträger und eine Sensorelektronik in das Bechergehäuse eingeführt sind.

Einen stabförmigen Magnetfeldsensor mit einem Außengehäuse und einer Leiterplatte offenbart DE 10 2014 205 308 B3. Das Außengehäuse ist ein Kunststoffspritzgussbauteil und bettet einen Sensorkopf mit einer Positionierhülse, einer Hallsonde und einem Permanentmagneten ein.

Aufgabe der Erfindung ist es, einen Magnetfeldsensor der eingangs genannter Art zu schaffen, der eine hohe Manipulationssicherheit aufweist.

Diese Aufgabe wird erfindungsgemäß gelöst mit einem Magnetfeldsensor nach Anspruch 1.

Die Innenquerschnittserweiterung des Sensorgehäuses kann insbesondere eine Vergrößerung eines Innendurchmessers des Sensorgehäuses, z. B. ein Innenabsatz an dem Sensorgehäuse, sein. Die Einführrichtung ist die Richtung eines Einführens oder Einsetzens der Leiterplatte in das Sensorgehäuse bei einer Herstellung, insbesondere Montage, des Magnetfeldsensors. Die Leiterplatte wird vorzugsweise in Richtung eines Sensorkopfes, der im montierten Zustand des Magnetfeldsensors ein Sensorelement umfasst, in das Sensorgehäuse eingeführt. Vorzugsweise ist der Magnetfeldsensor stabförmig ausgebildet.

In Einführrichtung der Leiterplatte ist der Innenquerschnitt des Sensorgehäuses hinter der Innenquerschnittserweiterung größer als vor der Innenquerschnittserweiterung des Sensorgehäuses. Die Leiterplatte weist das erste Widerhakenelement vorzugsweise an dem ersten Leiterplattenende auf. Das Widerhakenelement ist derart ausgebildet, dass es sich vorzugsweise bei einer Entnahme, insbesondere einem Herausziehen, der Leiterplatte aus dem Sensorgehäuse mit und/oder an der Innenquerschnittserweiterung verhakt. In Einführrichtung vorzugsweise unmittelbar hinter dem ersten Widerhakenelement weist die Leiterplatte das erste leiterplattenmontierte Bauteil auf.

Das leiterplattenmontierte Bauteil ist ein auf der Leiterplatte montiertes Bauteil und somit an der Leiterplatte angeordnet und befestigt. Das leiterplattenmontierte Bauteil kann z. B. ein Sensorelement oder ein Teil eines Sensorelementes des Magnetfeldsensors sein. Die Leiterplatte weist zahlreiche, insbesondere elektronische, Bauteile auf, von welchen Bauteilen eines das erfindungsgemäße leiterplattenmontierte Bauteil ist.

Der erfindungsgemäße Magnetfeldsensor kann insbesondere ein Bewegungssensor sein, der einem Fahrtenschreiber Bewegungssignale zur Verfügung stellt. Der Magnetfeldsensor und der Fahrtenschreiber können somit Bestandteil eines Fahrtenschreibersystems sein, wobei der Magnetfeldsensor und der Fahrtenschreiber elektrisch, beispielsweise mittels einer Kabelverbindung, verbunden sind. Die Bewegungssignale, die insbesondere Echtzeitsignale sein können, sind vorzugsweise ein Maß für eine Fahrgeschwindigkeit und/oder für eine zurückgelegte Fahrstrecke eines Kraftfahrzeugs.

Vorzugsweise ist der Magnetfeldsensor dazu ausgebildet, in ein Fahrzeuggetriebe des Kraftfahrzeugs eingeschraubt oder eingesteckt zu werden und ein Impulsrad, z. B. ein Getriebezahnrad, abzutasten, das sich in dem Getriebe befindet. Vorzugsweise stellt der Magnetfeldsensor auch eine kryptologisch abgesicherte Datenschnittstelle bereit, über welche unter anderem Daten zu einer Überprüfung der Bewegungssignale dem Fahrtenschreiber zur Verfügung gestellt werden können.

Von besonderem Vorteil ist bei der Erfindung, dass ein unzulässiger Ausbau der Leiterplatte aus dem Sensorgehäuse - um z. B. mit einer Absicht, Daten und/oder Signale des Magnetfeldsensors zu manipulieren (so dass die Bewegungssignale z. B. einen Stillstand des Kraftfahrzeugs vorgeben, obwohl das Kraftfahrzeug tatsächlich fährt), Bauteile auf der Leiterplatte auszutauschen - zu einer irreversiblen Zerstörung führt, da das erste leiterplattenmontierte Bauteil mittels des Widerhakenelements bei einer Entnahme der Leiterplatte aus dem Sensorgehäuse entgegen der Einführrichtung von der Leiterplatte abgerissen oder abgeschert wird. Das führt regelmäßig nicht nur zu Schäden an dem ersten leiterplattenmontierten Bauteil, sondern auch an der Leiterplatte selbst. Der erfindungsgemäße Magnetfeldsensor weist somit einen besonders hohen Manipulationsschutz auf. Von besonderem Vorteil ist dabei auch, dass ein solcher erfindungsgemäßer Manipulationsschutz sehr kostengünstig verwirklicht werden kann.

Mittels des Widerhakenelements und der Innenquerschnittserweiterung wird ein mechanischer Rückhaltemechanismus gebildet, der sicherstellt, dass ein zerstörungsfreies Herausziehen der Leiterplatte aus dem Sensorgehäuse nicht möglich ist. Wird dennoch mit erhöhtem Kraftaufwand die Leiterplatte aus dem Sensorgehäuse herausgezogen, wird entweder zumindest das leiterplattenmontierte Bauteil oder gegebenenfalls ein Teil der Leiterplatte abgerissen oder abgeschert. Durch eine solche Zerstörung ist im Nachhinein ein auch nur scheinbar ordnungsgemäßes Betreiben des Magnetfeldsensors nicht mehr möglich.

Das Sensorgehäuse kann z. B. aus einem metallischen Werkstoff bestehen. Beispielsweise kann das Sensorgehäuse aus einem Aluminiumwerkstoff bestehen. Das Sensorgehäuse kann beispielsweise durch ein Anschlusselementgehäuseteil des Magnetfeldsensors verschlossen sein. Das Anschlusselementgehäuseteil kann z. B. ein als Stecker ausgebildetes Anschlusselement oder beispielsweise einen Gehäusedeckel mit einem integrierten Kabelanschluss aufweisen.

Die Erfindung zeigt eine wirksame Maßnahme auf, die eine Manipulation des Magnetfeldsensors zumindest wesentlich erschwert, wenn nicht gar verhindert. Um an elektronische Bauteile auf der Leiterplatte zu kommen und Zugang zu signaldetektionsrelevanten Bauteilen zu erlangen, müsste die Leiterplatte aus dem Sensorgehäuse entnommen werden. Signaldetektionsrelevante Bauteile sind vorzugsweise im Sensorkopf angeordnet und umfassen zum Beispiel einen Magnet, Magnethalter und Hall-IC. Außerdem können auch weitere auf der Leiterplatte angeordnete elektronische Bauteile im weiteren Signalverlauf signaldetektionsrelevant sein. Mit der Erfindung ist eine Entnahme der Leiterplatte aus dem Sensorgehäuse nicht zerstörungsfrei möglich.

Man könnte sich vorstellen, dass das Widerhakenelement starr mit der Leiterplatte verbunden ist und dass bei einem Versuch, die Leiterplatte aus dem Sensorgehäuse herauszuziehen, zumindest das Widerhakenelement und gegebenenfalls mit diesem die Leiterplatte zerstört wird. Hingegen wird vorteilhaft eine zusätzlich erhöhte Manipulationssicherheit erreicht, da gemäß der Erfindung das Widerhakenelement gegenüber der Leiterplatte verschiebbar ist. Dabei ist das Widerhakenelement gegenüber der Leiterplatte zumindest in Einführrichtung der Leiterplatte in das Sensorgehäuse verschiebbar. Aufgrund der Verschiebbarkeit des Widerhakenelements wird das hinter dem Widerhakenelement angeordnete erste leiterplattenmontierte Bauteil von der Leiterplatte abgetrennt, z. B. abgeschert, wenn die Leiterplatte aus dem Sensorgehäuse entnommen, insbesondere herausgezogen, wird.

Gemäß einer anderen vorteilhaften Weiterbildung der Erfindung weist das Widerhakenelement einen Widerhaken auf und ist derart ausgebildet, dass sich der Widerhaken bei einem Entnehmen der Leiterplatte aus dem Sensorgehäuse entgegen der Einführrichtung an der Innenquerschnittserweiterung verhakt. Der Widerhaken bleibt somit beim Entnehmen der Leiterplatte an der Innenquerschnittserweiterung hängen. Der Widerhaken ist ferner vorzugsweise derart ausgebildet, dass er in Richtung der Leiterplatte nachgiebig, beispielsweise federnd, ausgebildet ist, so dass er sich bei einem Einsetzen, z. B. Einführen, der Leiterplatte in das Sensorgehäuse in Richtung der Leiterplatte bewegt, vorzugsweise sich an die Leiterplatte anlegt.

Einer anderen vorteilhaften Weiterbildung der Erfindung entsprechend weist das erste Widerhakenelement ein das erste leiterplattenmontierte Bauteil fassendes Führungselement auf. Mittels des Führungselements wird das leiterplattenmontierte Bauteil bei einer Entnahme, insbesondere einem Herausziehen, der Leiterplatte aus dem Sensorgehäuse geführt, so dass das leiterplattenmontierte Bauteil besonders zuverlässig von der Leiterplatte während der Entnahme getrennt und somit ein Manipulationsversuch sicher erkannt werden kann. Das Führungselement kann z. B. ein Halteelement und/oder ein Klammerelement sein.

Gemäß einer anderen vorteilhaften Weiterbildung der Erfindung ist das erste leiterplattenmontierte Bauteil ein Magnet oder ein Hall-Element, z. B. Hall-IC. Somit wird bei einer unzulässigen Entnahme der Leiterplatte aus dem Sensorgehäuse ein besonders wesentliches Bauteil des Magnetfeldsensors, nämlich ein Sensorelement oder zumindest ein Teil eines Sensorelements, von der Leiterplatte getrennt und somit dessen Verbindung mit der Leiterplatte zerstört. Der Magnet kann beispielsweise ein Ringmagnet sein. Auch kann der Magnet das Hall-Element umgreifen oder umschließen.

Die Manipulationssicherheit kann vorteilhaft zusätzlich weiter erhöht werden, wenn gemäß einer anderen Weiterbildung der Erfindung zwischen der Innenquerschnittserweiterung und dem ersten Widerhakenelement ein zweites Widerhakenelement angeordnet ist und wenn zwischen dem zweiten Widerhakenelement und dem ersten Widerhakenelement ein zweites leiterplattenmontiertes Bauteil angeordnet ist. Das zweite Widerhakenelement ist vorzugsweise verschiebbar gegenüber der Leiterplatte angeordnet. Vorzugsweise weist das zweite Widerhakenelement einen Widerhaken entsprechend dem ersten Widerhakenelement auf. Das zweite leiterplattenmontierte Bauteil befindet sich in Einführrichtung der Leiterplatte in das Sensorgehäuse hinter dem zweiten Widerhakenelement, und zwar vorzugsweise unmittelbar hinter dem zweiten Widerhakenelement. Bei einem Herausziehen der Leiterplatte aus dem Sensorgehäuse wird aufgrund des zweiten Widerhakenelements nicht nur das erste leiterplattenmontierte Bauteil (von dem ersten Widerhakenelement), sondern auch das zweite leiterplattenmontierte Bauteil (von dem zweiten Widerhakenelement) abgerissen oder abgeschert.

Die Innenquerschnittserweiterung könnte z. B. rampenförmig ausgebildet sein. Hingegen ist gemäß einer vorteilhaften Weiterbildung der Erfindung die Innenquerschnittserweiterung als Innenabsatz an dem Sensorgehäuse ausgebildet. Auf diese Weise kann ein besonders einfacher Aufbau des Magnetfeldsensors erreicht werden. Zudem wird mittels des Innenabsatzes ein besonders zuverlässiges Verhaken des ersten Widerhakenelements und ggf. auch des zweiten Widerhakenelements mit oder an der Innenquerschnittserweiterung bei einer unzulässigen Entnahme der Leiterplatte aus dem Sensorgehäuse ermöglicht.

Gemäß der Erfindung wird die Innenquerschnittserweiterung von einer in das Sensorgehäuse eingesetzten Lochscheibe gebildet. Die Lochscheibe ist somit Bestandteil des Sensorgehäuses. Die Lochscheibe kann insbesondere eine Ringscheibe sein.

Gemäß der Erfindung ist das Sensorgehäuse gestuft ausgebildet, wobei in Einführrichtung, nämlich in Einführrichtung der Leiterplatte in das Sensorgehäuse, ein größerer Innenquerschnitt des Sensorgehäuses mit einer Stufe in einen kleineren Innenquerschnitt übergeht und wobei die Lochscheibe an der Stufe anliegt und einen Lochscheibeninnenquerschnitt aufweist, der kleiner ist als der kleinere Innenquerschnitt des Sensorgehäuses. Der Lochscheibeninnenquerschnitt entspricht dem Loch der Lochscheibe. Mit dieser Ausbildung der Erfindung kann vorteilhaft ein vorgegebenes Sensorgehäuse an Leiterplatten unterschiedlicher Abmessungen durch Auswahl einer jeweils geeigneten Lochscheibe angepasst werden.

Einer vorteilhaften Weiterbildung der Erfindung gemäß weist die Leiterplatte im Bereich der Lochscheibe eine Leiterplattenbreite auf, die kleiner ist als ein Lochscheibeninnendurchmesser, so dass ein Abstand zwischen Leiterplatte und Lochscheibe besteht. Der Abstand zwischen Leiterplatte und Lochscheibe besteht in einer Richtung senkrecht zur Einführrichtung. Üblicherweise ist die Einführrichtung parallel zu einer Sensorlängsachse des Magnetfeldsensors angeordnet, so dass die Richtung senkrecht zur Einführrichtung auch eine Richtung senkrecht zur Sensorlängsachse ist. Aufgrund des Abstands zwischen Leiterplatte und Lochscheibe liegt keine Berührung von Leiterplatte und Lochscheibe vor.

Gemäß einer anderen vorteilhaften Weiterbildung der Erfindung ist ein das erste Leiterplattenende aufnehmendes erstes Sensorgehäuseende fest verschlossen. Das erste Sensorgehäuseende kann z. B. topfförmig ausgebildet sein. In diesem Fall bildet das Sensorgehäuse an dem ersten Sensorgehäuseende einen Gehäusetopf. Die Manipulationssicherheit kann so vorteilhaft weiter erhöht werden, da eine Entnahme der Leiterplatte in Einführrichtung aus dem Sensorgehäuse ohne Zerstörung des Sensorgehäuses ausgeschlossen wird.

Ausführungsbeispiele der Erfindung sind in der Zeichnung skizzenhaft und schematisiert dargestellt und werden im Folgenden näher beschrieben. Es zeigen:
- Fig. 1: einen Magnetfeldsensor in einem montierten Zustand,
- Fig. 2: den Magnetfeldsensor aus Fig. 1 während einer Montage einer Leiterplatte,
- Fig. 3: den Magnetfeldsensor aus Fig. 1 während einer Demontage der Leiterplatte,
- Fig. 4: Einzelteile des Magnetfeldsensors aus Figur 1,
- Fig. 5: einen anderen Magnetfeldsensor,
- Fig. 6: eine Leiterplatte des Magnetfeldsensors nach Figur 5,
- Fig. 7: weitere Einzelteile eines Magnetfeldsensors und
- Fig. 8: einen Magnetfeldsensor mit einem Anschlusselementgehäuseteil.

Sich jeweils entsprechende Element sind in allen Figuren mit gleichen Bezugszeichen versehen.

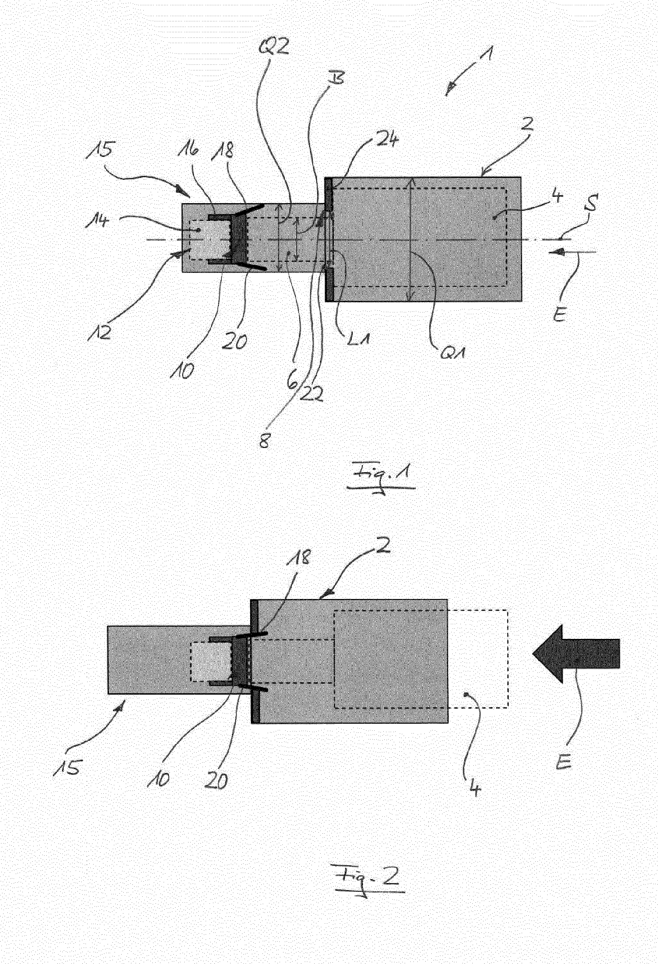

Fig. 1 zeigt in einer schematisierten, skizzenhaften Darstellung einen Magnetfeldsensor 1 mit einem Sensorgehäuse 2 und mit einer in dem Sensorgehäuse 2 angeordneten, gestrichelt dargestellten Leiterplatte 4. Die Leiterplatte 4 ist in einer durch einen Pfeil E symbolisierten Einführrichtung in das Sensorgehäuse 2 eingeführt. Der Magnetfeldsensor 1 ist stabförmig ausgebildet.

In Figur 1 ist erkennbar, dass in dem montierten Zustand des Magnetfeldsensors 1 die Leiterplatte 4 mit einem ersten Leiterplattenende 6 eine Innenquerschnittserweiterung 8 des Sensorgehäuses 2 durchgreifend in das Sensorgehäuse 2 in der durch den Pfeil E symbolisierten Einführrichtung eingesetzt ist. Die Leiterplatte 4 weist in Einführrichtung hinter der Innenquerschnittserweiterung 8 ein erstes Widerhakenelement 10 auf. Außerdem weist die Leiterplatte 4 in Einführrichtung hinter dem ersten Widerhakenelement 10 ein erstes leiterplattenmontiertes Bauteil 12 auf.

Das erste leiterplattenmontierte Bauteil 12 ist in diesem Ausführungsbeispiel ein Magnet 14, insbesondere ein Permanentmagnet. Der Magnet ist im Bereich eines Sensorkopfes 15 des Magnetfeldsensors 1 angeordnet. Außerdem weist das erste Widerhakenelement 10, das in diesem Ausführungsbeispiel auch ein Magnethalter für den Magneten 14 ist, ein das erste leiterplattenmontierte Bauteil 12 fassendes Führungselement 16 auf. Zudem weist das Widerhakenelement 10 zwei Widerhaken 18, 20 auf. Die Widerhaken 18, 20 sind an gegenüberliegenden Seiten des Widerhakenelements 10 angeordnet. Sie sind nachgiebig und können z. B. auch als Rückhalteklammern bezeichnet werden, die im Ruhezustand nach außen, das heißt von der Leiterplatte 4 weg, gebogen sind.

Die Innenquerschnittserweiterung 8 ist als Innenabsatz 22 an dem Sensorgehäuse 2 ausgebildet. Gebildet wird die Innenquerschnittserweiterung 8 von einer in das Sensorgehäuse 2 eingesetzten Lochscheibe 24. Das Sensorgehäuse 2 ist gestuft ausgebildet, wobei in der durch den Pfeil E symbolisierten Einführrichtung der Leiterplatte 4 in das Sensorgehäuse 2 ein größerer Innenquerschnitt Q1 des Sensorgehäuses 2 mit einer Stufe in einen kleineren Innenquerschnitt Q2 übergeht. Die Lochscheibe 24 liegt an der Stufe des Sensorgehäuses 2 an und weist einen Lochscheibeninnenquerschnitt L1 auf, der kleiner ist als der kleinere Innenquerschnitt Q2 des Sensorgehäuses 2.

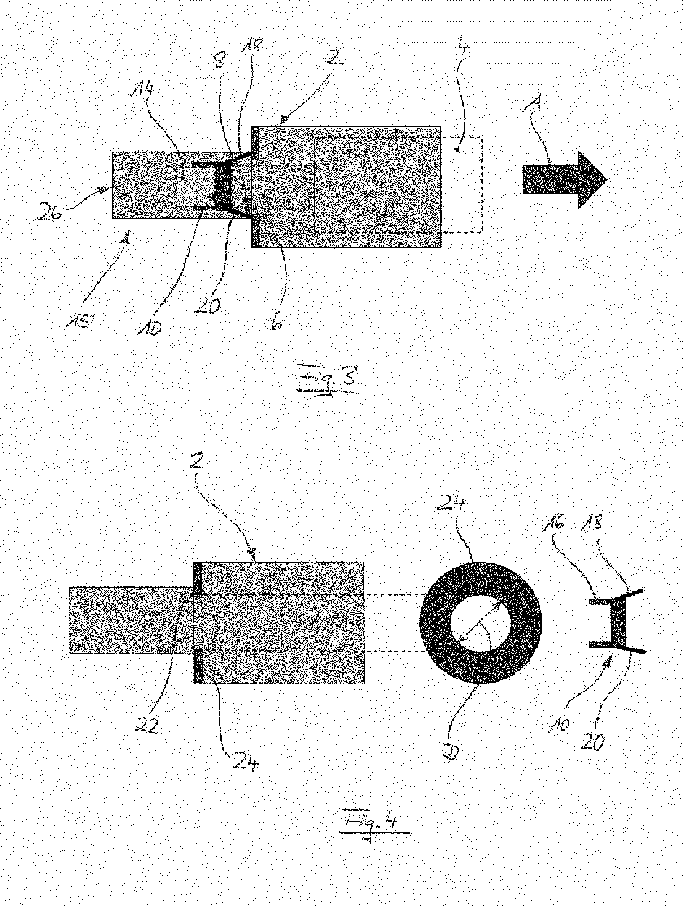

Zudem ist erkennbar, dass die Leiterplatte 4 im Bereich der Lochscheibe 24 eine Leiterplattenbreite B aufweist, die kleiner ist als ein Lochscheibeninnendurchmesser D (siehe Figur 4), so dass in einer Richtung senkrecht zur Einführrichtung der Leiterplatte 4 in das Sensorgehäuse 2 ein Abstand zwischen Leiterplatte 4 und Lochscheibe 24 besteht. Der Abstand bedeutet, dass die Leiterplatte 4 und die Lochscheibe 24 keine Berührung und keine mechanische Verbindung aufweisen. Die Einführrichtung ist parallel einer Sensorlängsachse S des Magnetfeldsensors 1 angeordnet.

In Figur 2 ist erkennbar, dass bei einem Einführen oder Einsetzen der Leiterplatte 4 in der durch den Pfeil E symbolisierten Einführrichtung in das Sensorgehäuse 2 die Widerhaken 18, 20 des Widerhakenelements 10 an der Lochscheibe 24 in Richtung der Leiterplatte 4, das heißt in einer Richtung senkrecht zu der Einführrichtung, niedergedrückt werden und so die Lochscheibe 24 passieren. Die Widerhaken 18, 20 geben somit nach und erlauben, dass die Leiterplatte 4 mit dem Widerhakenelement 10 und dem Magneten 14 durch die Lochscheibe 24 geschoben werden kann. Nach dem Passieren der Lochscheibe 24 spreizen sich die Widerhaken 18, 20 und erreichen ihre in Figur 1 dargestellte Endposition.

Eine Demontage oder ein Entnehmen der Leiterplatte 4 aus dem Sensorgehäuse 2 in einer der Einführrichtung entgegengesetzten, durch einen Pfeil A symbolisierten Ausbaurichtung ist in Figur 3 dargestellt. Das Entnehmen der Leiterplatte 4 erfolgt z. B. durch ein Herausziehen der Leiterplatte 4 aus dem Sensorgehäuse 2.

Es ist erkennbar, dass die Widerhaken 18, 20 des Widerhakenelements 10 derart ausgebildet sind, dass sich die Widerhaken 18, 20 bei einem Entnehmen der Leiterplatte 4 aus dem Sensorgehäuse 2 entgegen der Einführrichtung an der Innenquerschnittserweiterung 8 des Sensorgehäuses 2 verhaken. Bei weiterer Bewegung der Leiterplatte 4 in der Ausbaurichtung wird das Widerhakenelement 10 an der Leiterplatte 4 abgezogen, da es zumindest in Einführrichtung gegenüber der Leiterplatte 4 verschiebbar ist. Bei dem Abziehen des Widerhakenelements 10 von der Leiterplatte 4 nimmt das Widerhakenelement 10 den Magneten 14 mit und schert diesen von der Leiterplatte 4 ab.

Ein das erste Leiterplattenende 6 aufnehmendes erstes Sensorgehäuseende 26, das sich an dem Sensorkopf 15 befindet, ist fest verschlossen. Aus diesem Grund kommt für eine Entnahme der Leiterplatte 4 aus dem Sensorgehäuse 2 ohne Zerstörung des Sensorgehäuses 2 grundsätzlich nur eine Entnahme in der durch den Pfeil A symbolisierten Ausbaurichtung in Frage. Zudem ist ohne eine Zerstörung des Sensorgehäuses 2 auch ein anderweitiger Zugang zu dem Magneten 14, insbesondere von dem ersten Sensorgehäuseende 26 her, nicht möglich.

Zur weiteren Verdeutlichung des Aufbaus des Magnetfeldsensors 1 zeigt Figur 4 das Sensorgehäuse 2 mit der Lochscheibe 24 sowie die Lochscheibe 24 zudem in einer Draufsicht. Außerdem ist hier das Widerhakenelement 10 in Einzelansicht dargestellt.

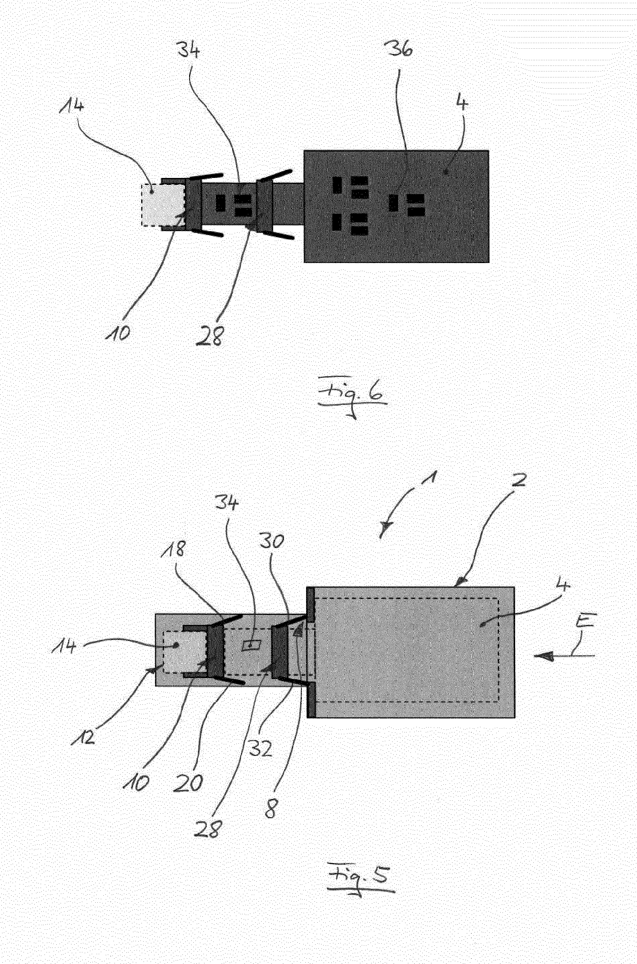

Eine andere Ausführungsform eines Magnetfeldsensors 1 zeigt Figur 5. Der Magnetfeldsensor 1 nach Figur 5 unterscheidet sich von dem vorher beschriebenen Magnetfeldsensor dadurch, dass zwischen einer Innenquerschnittserweiterung 8 des Sensorgehäuses 2 und einem ersten Widerhakenelement 10 ein zweites Widerhakenelement 28 angeordnet ist. Ferner ist zwischen dem zweiten Widerhakenelement 28, das zwei Widerhaken 30, 32 aufweist, und dem ersten Widerhakenelement 10, das zwei Widerhaken 18, 20 aufweist, ein zweites leiterplattenmontiertes Bauteil 34 angeordnet.

Das erste Widerhakenelement 10 sowie das zweite Widerhakenelement 28 sind in einer durch einen Pfeil E symbolisierten Einführrichtung der Leiterplatte 4 in das Sensorgehäuse 2 verschiebbar. Somit wird bei einer Entnahme der Leiterplatte 4 aus dem Sensorgehäuse 2 in einer der Einführrichtung entgegengesetzten Ausbaurichtung von dem zweiten Widerhakenelement 28 das zweite leiterplattenmontierte Bauteil 34 sowie von dem ersten Widerhakenelement 10 ein Magnet 14, der ein erstes leiterplattenmontiertes Bauteil 12 ist, jeweils von der Leiterplatte 4 abgeschert.

Die Leiterplatte 4 des Magnetfeldsensors 1 nach Figur 5 vor der Montage zeigt Figur 6. Die Leiterplatte 4 weist elektronische Bauteile 36 sowie die beiden Widerhakenelemente 10, 28 und den Magneten 14 auf. Eines der elektronischen Bauteile 36 ist das zweite leiterplattenmontierte Bauteil 34.

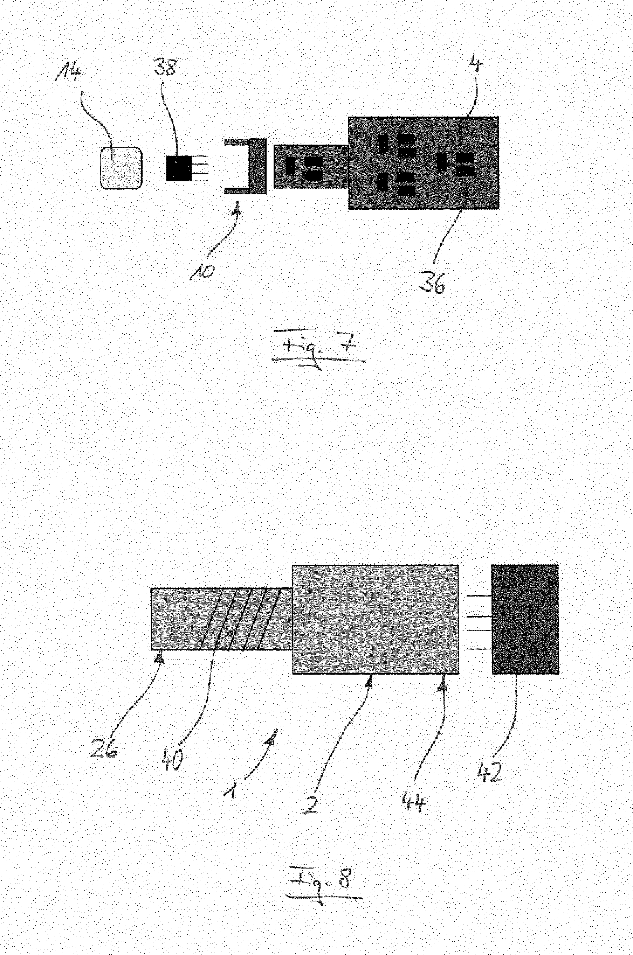

Zur zusätzlichen Verdeutlichung des Aufbaus eines Magnetfeldsensors, beispielsweise eines Magnetfeldsensors 1 nach Figur 1, zeigt Figur 7 eine mit elektronischen Bauteilen 36 bestückte Leiterplatte 4 in Einzelansicht. Außerdem sind in Einzelansicht ein Widerhakenelement 10 sowie ein Magnet 14 und ein Hall-IC 38 gezeigt; diese Bauteile sind ebenso wie die elektronischen Bauteile 36 in einem montierten Zustand der Leiterplatte 4 auf dieser angeordnet.

In Figur 8 ist ein weiterer Magnetfeldsensor 1 dargestellt. Dieser Magnetfeldsensor 1 weist ein Sensorgehäuse 2 mit einer hier nicht dargestellten Leiterplatte entsprechend den vorher beschriebenen Ausführungsbeispielen auf. An einem ersten Sensorgehäuseende 26 weist das Sensorgehäuse 2 ein Außengewinde 40 zum Einschrauben des Magnetfeldsensors z. B. in ein Getriebegehäuse eines Getriebes eines Kraftfahrzeugs auf.

Außerdem weist der Magnetfeldsensor 1 an einem dem ersten Sensorgehäuseende 26 gegenüberliegenden zweiten Sensorgehäuseende 44 ein Anschlusselementgehäuseteil 42 zur Verbindung des Magnetfeldsensors 1 z. B. mit einem Fahrtenschreiber des Kraftfahrzeugs auf. Das Anschlusselementgehäuseteil 42 kann beispielsweise einen Steckeranschluss aufweisen.

## Patentansprüche

1. Magnetfeldsensor (1) mit einem Sensorgehäuse (2) und mit einer in dem Sensorgehäuse (2) angeordneten Leiterplatte (4), wobei die Leiterplatte (4) mit einem ersten Leiterplattenende (6) eine Innenquerschnittserweiterung (8) des Sensorgehäuses (2) durchgreifend in das Sensorgehäuse (2) in einer Einführrichtung eingesetzt ist und wobei die Leiterplatte (4) in Einführrichtung hinter der Innenquerschnittserweiterung (8) ein erstes Widerhakenelement (10) und in Einführrichtung hinter dem ersten Widerhakenelement (10) ein erstes leiterplattenmontiertes Bauteil (12) aufweist, **dadurch gekennzeichnet, dass** das Widerhakenelement (10) gegenüber der Leiterplatte (4) verschiebbar ist, so dass das erste leiterplattenmontierte Bauteil (12) von der Leiterplatte (4) abgetrennt wird, wenn die Leiterplatte (4) aus dem Sensorgehäuse (2) herausgezogen wird, dass die Innenquerschnittserweiterung (8) von einer in das Sensorgehäuse (2) eingesetzten Lochscheibe (24) gebildet wird und dass das Sensorgehäuse (2) gestuft ausgebildet ist, wobei in Einführrichtung ein größerer Innenquerschnitt (Q1) des Sensorgehäuses (2) mit einer Stufe in einen kleineren Innenquerschnitt (Q2) übergeht und wobei die Lochscheibe (24) an der Stufe anliegt und einen Lochscheibeninnenquerschnitt (L1) aufweist, der kleiner ist als der kleinere Innenquerschnitt (Q2) des Sensorgehäuses (2).

2. Magnetfeldsensor nach Anspruch 1, **dadurch gekennzeichnet, dass** das Widerhakenelement (10) einen Widerhaken (18) aufweist und derart ausgebildet ist, dass sich der Widerhaken (18) bei einem Entnehmen der Leiterplatte (4) aus dem Sensorgehäuse (2) entgegen der Einführrichtung an der Innenquerschnittserweiterung (8) verhakt.

3. Magnetfeldsensor nach einem der vorhergehenden Ansprüche, **dadurch gekennzeichnet, dass** das erste Widerhakenelement (10) ein das erste leiterplattenmontierte Bauteil (12) fassendes Führungselement (16) aufweist.

4. Magnetfeldsensor nach einem der vorhergehenden Ansprüche, **dadurch gekennzeichnet, dass** das erste leiterplattenmontierte Bauteil (12) ein Magnet (14) oder ein Hall-Element ist.

5. Magnetfeldsensor nach einem der vorhergehenden Ansprüche, **dadurch gekennzeichnet, dass** zwischen der Innenquerschnittserweiterung (8) und dem ersten Widerhakenelement (10) ein zweites Widerhakenelement (28) angeordnet ist und dass zwischen dem zweiten Widerhakenelement (28) und dem ersten Widerhakenelement (10) ein zweites leiterplattenmontiertes Bauteil (34) angeordnet ist.

6. Magnetfeldsensor nach einem der vorhergehenden Ansprüche, **dadurch gekennzeichnet, dass** die Innenquerschnittserweiterung (8) als durch die Lochscheibe (24) gebildeter Innenabsatz (22) an dem Sensorgehäuse (2) ausgebildet ist.

7. Magnetfeldsensor nach einem der vorhergehenden Ansprüche, **dadurch gekennzeichnet, dass** die Leiterplatte (4) im Bereich der Lochscheibe (24) eine Leiterplattenbreite (B) aufweist, die kleiner ist als ein Lochscheibeninnendurchmesser (D), so dass ein Abstand zwischen Leiterplatte (4) und Lochscheibe (24) besteht.

8. Magnetfeldsensor nach einem der vorhergehenden Ansprüche, **dadurch gekennzeichnet, dass** ein das erste Leiterplattenende (6) aufnehmendes erstes Sensorgehäuseende (26) fest verschlossen ist.

## Claims

1. Magnetic field sensor (1) having a sensor housing (2) and having a printed circuit board (4) arranged in the sensor housing (2), wherein the printed circuit board (4) is inserted into the sensor housing (2) in an insertion direction, with a first printed circuit board end (6) reaching through an internal cross-sectional widening (8) of the sensor housing (2), and wherein the printed circuit board (4) has a first barb element (10) behind the internal cross-sectional widening (8) in the insertion direction and a first printed circuit board-mounted component (12) behind the first barb element (10) in the insertion direction, **characterized in that** the barb element (10) is displaceable with respect to the printed circuit board (4), so that when the printed circuit board (4) is pulled out of the sensor housing (2), the first printed circuit board-mounted component (12) is separated from the printed circuit board (4), **in that** the internal cross-sectional widening (8) is formed by a perforated disc (24) inserted into the sensor housing (2), and **in that** the sensor housing (2) is stepped, wherein a larger internal cross section (Q1) of the sensor housing (2) merges into a smaller internal cross section (Q2) in the insertion direction by way of a step, and wherein the perforated disc (24) rests on the step and has a perforated disc internal cross section (L1) which is smaller than the smaller internal cross section (Q2) of the sensor housing (2).

2. Magnetic field sensor according to Claim 1, **characterized in that** the barb element (10) has a barb (18) and is designed in such a way that when the printed circuit board (4) is removed from the sensor housing (2) counter to the insertion direction, the barb (18) hooks on the internal cross-sectional widening (8).

3. Magnetic field sensor according to one of the preceding claims, **characterized in that** the first barb element (10) has a guide element (16) grasping the first printed circuit board-mounted component (12).

4. Magnetic field sensor according to one of the preceding claims, **characterized in that** the first printed circuit board-mounted component (12) is a magnet (14) or a Hall element.

5. Magnetic field sensor according to one of the preceding claims, **characterized in that** a second barb element (28) is arranged between the internal cross-sectional widening (8) and the first barb element (10), and a second printed circuit board-mounted component (34) is arranged between the second barb element (28) and the first barb element (10).

6. Magnetic field sensor according to one of the preceding claims, **characterized in that** the internal cross-sectional widening (8) is formed as an inner shoulder (22) on the sensor housing (2), formed by the perforated disc (24).

7. Magnetic field sensor according to one of the preceding claims, **characterized in that** in the region of the perforated disc (24), the printed circuit board (4) has a printed circuit board width (B) which is smaller than a perforated disc inner diameter (D), so that there is a distance between the printed circuit board (4) and the perforated disc (24).

8. Magnetic field sensor according to one of the preceding claims, **characterized in that** a first sensor housing end (26) receiving the first printed circuit board end (6) is firmly closed.

## Revendications

1. Capteur de champ magnétique (1), comprenant un boîtier de capteur (2) et une carte de circuits imprimés (4) disposée dans le boîtier de capteur (2), dans lequel la carte de circuits imprimés (4) est insérée dans le boîtier de capteur (2) par une première extrémité de carte de circuits imprimés (6) en traversant un élargissement de section transversale intérieure (8) du boîtier de capteur (2) dans une direction d'introduction, et dans lequel la carte de circuits imprimés (4) présente un premier élément d'accrochage (10) dans la direction d'introduction derrière l'élargissement de section transversale intérieure (8), et présente un premier composant (12) monté sur la carte de circuits imprimés dans la direction d'introduction derrière le premier élément d'accrochage (10),
**caractérisé en ce que** l'élément d'accrochage (10) est coulissant par rapport à la carte de circuits imprimés (4) de sorte que le premier composant (12) monté sur la carte de circuits imprimés est détaché de la carte de circuits imprimés (4) si la carte de circuits imprimés (4) est retirée du boîtier de capteur (2), **en ce que** l'élargissement de section transversale intérieure (8) est formé par un disque perforé (24) inséré dans le boîtier de capteur (2), et **en ce que** le boîtier de capteur (2) est réalisé de manière étagée, dans lequel, dans la direction d'introduction, une section transversale intérieure supérieure (Q1) du boîtier de capteur (2) passe par un gradin à une section transversale intérieure inférieure (Q2), et dans lequel le disque perforé (24) est adjacent au gradin et présente une section transversale intérieure de disque perforé (L1) qui est inférieure à la section transversale intérieure inférieure (Q2) du boîtier de capteur (2).

2. Capteur de champ magnétique selon la revendication 1, **caractérisé en ce que** l'élément d'accrochage (10) présente un dispositif d'accrochage (18) et est réalisé de telle sorte que le dispositif d'accrochage (18) s'accroche au niveau de l'élargissement de section transversale intérieure (8) lors d'un retrait de la carte de circuits imprimés (4) du boîtier de capteur (2) à l'opposé de la direction d'introduction.

3. Capteur de champ magnétique selon l'une quelconque des revendications précédentes, **caractérisé en ce que** le premier élément d'accrochage (10) présente un premier élément de guidage (16) saisissant le premier composant (12) monté sur la carte de circuits imprimés.

4. Capteur de champ magnétique selon l'une quelconque des revendications précédentes, **caractérisé en ce que** le premier composant (12) monté sur la carte de circuits imprimés est un aimant (14) ou un élément à effet Hall.

5. Capteur de champ magnétique selon l'une quelconque des revendications précédentes, **caractérisé en ce qu'**un deuxième élément d'accrochage (28) est disposé entre l'élargissement de section transversale intérieure (8) et le premier élément d'accrochage (10), et **en ce qu'**un deuxième composant (34) monté sur la carte de circuits imprimés est disposé entre le deuxième élément d'accrochage (28) et le premier élément d'accrochage (10).

6. Capteur de champ magnétique selon l'une quelconque des revendications précédentes, **caractérisé en ce que** l'élargissement de section transversale intérieure (8) est réalisé sous la forme d'un épaulement intérieur (22), formé par le disque perforé (24), sur le boîtier de capteur (2).

7. Capteur de champ magnétique selon l'une quelconque des revendications précédentes, **caractérisé en ce que** la carte de circuits imprimés (4) présente au niveau du disque perforé (24) une largeur de carte de circuits imprimés (B) qui est inférieure à un diamètre intérieur de disque perforé (D) de sorte qu'il existe un intervalle entre la carte de circuits imprimés (4) et le disque perforé (24).

8. Capteur de champ magnétique selon l'une quelconque des revendications précédentes, **caractérisé en ce qu'**une première extrémité de boîtier de capteur (26) recevant la première extrémité de carte de circuits imprimés (6) est correctement fermée.
